# EUROPEAN PATENT APPLICATION

(11) **EP 4 851 998 A1**
(43) Date of publication of application: **09.12.2026**
(21) Application number: 24945303.6
(22) Date of filing: 25.10.2024
(51) Int. Cl.: G11C 8/08

(54) **MEMORY AND CONTROL METHOD**

(30) Priority: 18.06.2024 CN 202410792291
(71) Applicant: CXMT Corporation, Hefei City, Anhui Province 230601 (CN)
(72) Inventor: CHEN, Han, Hefei, Anhui 230601 (CN)
(74) Representative: Gulde & Partner
(86) International application number: PCT/CN2024/127337
(87) International publication number: WO 2025/260574

(57) **Abstract**

The present disclosure provides a memory and a control method. The memory includes at least: a redundant memory array and a normal memory array, where a word line in the redundant memory array is configured to repair a word line in the normal memory array, and the capacitance of a minimum memory unit in the redundant memory array is greater than the capacitance of a minimum memory unit in the normal memory array; and a sense amplifier, configured to amplify voltages of bit lines in the redundant memory array and the normal memory array.

## Description

### CROSS-REFERENCE TO RELATED APPLICATIONS

This application claims priority to Chinese Patent Application No. 202410792291.6, filed with the China National Intellectual Property Administration on June 18, 2024 and entitled "MEMORY AND CONTROL METHOD", which is incorporated herein by reference in its entirety.

### TECHNICAL FIELD

Embodiments of this application relate to the semiconductor field, and in particular, to a memory and a control method.

### BACKGROUND

As the input/output rate and the capacity of a memory increase, the control logic in the memory becomes more complex, and a memory cell is increasingly affected by noise. In addition, with the technological advances, people increasingly pay attention to a data security issue and a data stability issue of the memory. A common row hammer attack may cause data in the memory to be damaged. How to alleviate the impact of the row hammer attack and the noise on the memory is a major concern in the industry.

### SUMMARY

Embodiments of this application provide a memory and a control method, which at least helps weaken the impact of a row hammer attack and noise on the memory.

According to some embodiments of this application, an aspect of the embodiments of this application provides a memory. The memory includes at least: a redundant memory array and a normal memory array, where a word line in the redundant memory array is configured to repair a word line in the normal memory array, and the capacitance of a minimum memory unit in the redundant memory array is greater than the capacitance of a minimum memory unit in the normal memory array; and a sense amplifier, configured to amplify voltages of bit lines in the redundant memory array and the normal memory array.

In some embodiments, a multiplexer and a row decoder are further included in the memory. The multiplexer is configured to receive a normal row address, a redundant row address, and a first control signal, and a moment at which the redundant row address is received is later than a moment at which the normal row address is received; when the first control signal is in a sleep state, the row decoder receives the normal row address output by the multiplexer; when the first control signal is in an enabled state, the row decoder receives the redundant row address output by the multiplexer; and the first control signal is configured to represent whether a word line corresponding to the normal row address is damaged and is repaired, and the first control signal is in the sleep state before entering the enabled state.

In some embodiments, a first decoder, a comparator, and a first encoder are further included in the memory. An output terminal of the first decoder is connected to a first input terminal of the multiplexer, an output terminal of the comparator is connected to an input terminal of the first encoder, and an output terminal of the first encoder is connected to a second input terminal of the multiplexer; the first decoder is configured to receive a target row address and decode the target row address in a preset decoding manner, to output the normal row address; the comparator is configured to: compare the target row address with at least one repaired row address, and if the target row address matches one of the at least one repaired row address, generate the first control signal with the enabled state, and output flag information of the matched repaired row address; and the first encoder is configured to receive the flag information, and generate the redundant row address based on the flag information.

In some embodiments, an AND circuit is further included in the memory. A first input terminal of the AND circuit is connected to an output terminal of the multiplexer, a second input terminal of the AND circuit is configured to receive an enable signal, an output terminal of the AND circuit is connected to an input terminal of the row decoder, and the enable signal jumps to a high level before the multiplexer outputs the normal row address.

In some embodiments, both the minimum memory unit in the redundant memory array and the minimum memory unit in the normal memory array are one memory cell, and the capacitance of a memory cell in the redundant memory array is greater than the capacitance of a memory cell in the normal memory array; or the minimum memory unit in the redundant memory array includes at least two memory cells, and the minimum memory unit in the normal memory array is one memory cell.

In some embodiments, the at least two memory cells included in the minimum memory unit in the redundant memory array have the same row address and are connected to the same bit line.

In some embodiments, the at least two memory cells are connected to the same word line or at least two word lines having the same row address.

In some embodiments, an edge memory array and an intermediate memory array are included in the memory. In an extension direction of a bit line, the width of the edge memory array is equal to half the width of the intermediate memory array, the redundant memory array is located in the edge memory array, and the normal memory array is located in the intermediate memory array.

In some embodiments, the memory is further configured to perform offset cancellation on an internal transistor based on a compensation bit line or a reference bit line.

According to some embodiments of this application, another aspect of the embodiments of this application further provides a control method, applied to the memory according to any one of the foregoing embodiments. The control method includes the steps as follows. A target row address is compared with at least one repaired row address to determine whether they are matched, and first-time decoding is performed on the target row address to generate a normal row address. After the normal row address is generated, subsequent decoding is performed on the normal row address to determine a normal to-be-activated word line. A sense amplifier corresponding to the normal to-be-activated word line is controlled to perform an offset cancellation operation. If the target row address matches one of the at least one repaired row address, a redundant row address is generated based on flag information of the matched repaired row address, and a sense amplifier corresponding to the normal to-be-activated word line and not corresponding to the redundant row address is controlled to interrupt an offset cancellation operation, or the sense amplifier corresponding to the normal to-be-activated word line is controlled to interrupt the offset cancellation operation. After the redundant row address is generated, subsequent decoding is performed on the redundant row address to determine a redundant to-be-activated word line. A sense amplifier corresponding to the redundant to-be-activated word line is controlled to perform an offset cancellation operation.

In some embodiments, the sense amplifier corresponding to the normal to-be-activated word line performs an offset cancellation operation for a first preset time before the offset cancellation operation is interrupted, the sense amplifier corresponding to the redundant to-be-activated word line performs an offset cancellation operation for a second preset time, and the sum of the first preset time and the second preset time is a fixed value, or the second preset time has a minimum value.

In some embodiments, if the target row address does not match any of the at least one repaired row address, the sense amplifier corresponding to the normal to-be-activated word line performs an offset cancellation operation for a third preset time, the sum of the first preset time and the second preset time is a fixed value, the third preset time is less than or equal to the fixed value, and the second preset time is less than the third preset time.

### BRIEF DESCRIPTION OF DRAWINGS

One or more embodiments are exemplified with the figures in the accompanying drawings corresponding to the one or more embodiments. These example descriptions are not intended to limit the embodiments, and unless specifically stated, no scale limitations are constituted by the figures in the accompanying drawings.
FIG. 1 is a schematic structural diagram of a memory according to an embodiment of this application;
FIG. 2 is a schematic circuit diagram of a memory according to some embodiments of this application;
FIG. 3 to FIG. 6 are schematic structural diagrams of a minimum memory unit of a redundant memory array according to some embodiments of this application;
FIG. 7 is a schematic layout diagram of a memory according to some embodiments of this application;
FIG. 8 is a schematic circuit diagram of a sense amplifier according to some embodiments of this application; and
FIG. 9 is a time sequence diagram of a control method according to some embodiments of this application.

### DESCRIPTION OF EMBODIMENTS

The embodiments of this application are described in detail below with reference to the accompanying drawings. However, it may be understood by a person of ordinary skill in the art that in the embodiments of this application, many technical details are provided to enable readers to better understand this application. However, the technical solutions claimed in this application may be implemented even without these technical details and various changes and modifications made based on the following embodiments.

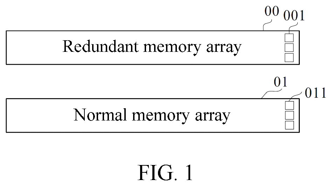

FIG. 1 is a schematic structural diagram of a memory according to an embodiment of this application.

Referring to FIG. 1, the memory includes: a redundant memory array 00 and a normal memory array 01, where a word line in the redundant memory array 00 is configured to repair a word line in the normal memory array 01, and the capacitance of a minimum memory unit 001 in the redundant memory array 00 is greater than the capacitance of a minimum memory unit 011 in the normal memory array 01; and a sense amplifier (not shown in the figure). The sense amplifier is configured to amplify voltages of bit lines in the redundant memory array 00 and the normal memory array 01.

The capacitance of the minimum memory unit 001 in the redundant memory array 00 is set to be relatively large, which helps weaken the impact of charge leakage caused by a row hammer (RHR) on the minimum memory unit 001 in the redundant memory array, to ensure that the redundant memory array 00 can effectively store data. In addition, due to the relatively large capacitance, after a charge sharing (CS) stage, a bit line corresponding to the minimum memory unit 001 in the redundant memory array 00 has more charges and a higher potential, or has fewer charges and a lower potential (which is compared with that of the bit line in the normal memory array 01 after the charge sharing stage). This helps weaken the impact of noise on data reading, and ensure that there is a proper voltage difference between the bit line and a reference bit line, thereby ensuring that data amplified by the sense amplifier is data stored in the minimum memory unit 001.

An embodiment of this application is described in more detail below with reference to the accompanying drawings.

Multiple normal memory arrays 01 and one or more redundant memory arrays 00 may be included in the memory. When a quantity of redundant memory arrays 00 is the same as a quantity of normal memory arrays 01, each normal memory array 01 has one corresponding and unique redundant memory array 00, and a complete memory array is formed by the normal memory array and the redundant memory array. When the quantity of redundant memory arrays 00 is less than the quantity of normal memory arrays 01, multiple normal memory arrays 01 often share one redundant memory array 00, thereby improving the utilization of redundant resources.

It may be understood that, the redundant memory array 00 and the normal memory array 01 are differently named based on different functions, and there is no limitation on locations. In a process of data writing, data is preferentially stored in the minimum memory unit in the normal memory array 01, and the minimum memory unit is connected to a word line and a bit line, and is limited by a row address and the bit line. When the word line in the normal memory array 01 is damaged for various reasons, and data cannot be written, a redundant word line is utilized to replace a normal word line, and the data is written into a minimum memory unit corresponding to the redundant word line, to implement word line repair. A row address of a damaged normal word line is recorded in a storage medium such as a register, a fuse component, or an anti-fuse component, and a mapping relationship between the row address of the damaged normal word line and a row address of the redundant word line is reserved, to ensure subsequent normal read and write.

In this embodiment of this application, the minimum memory unit 001 in the redundant memory array 00 and the minimum memory unit of the normal memory array 01 store the same amount of data. In some embodiments, the minimum memory unit 011 of the normal memory array 01 stores only one piece of data, e.g., 0 or 1. In some embodiments, an access transistor and a storage capacitor are included in the minimum memory unit, the gate of the access transistor is connected to the word line, and the source and the drain of the access transistor are respectively connected to the bit line and the storage capacitor. When the access transistor is turned on, a charge is shared between the storage capacitor and the bit line. The capacitance of the minimum memory unit is a storage capacitance.

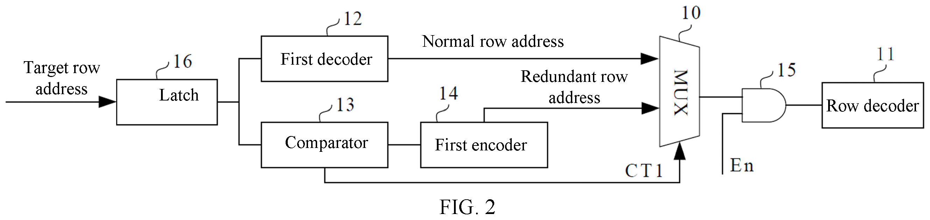

In some embodiments, referring to FIG. 2, a multiplexer 10 and a row decoder 11 are further included in the memory. The multiplexer 10 is configured to receive a normal row address, a redundant row address, and a first control signal CT1, and a moment at which the redundant row address is received is later than a moment at which the normal row address is received. When the first control signal CT1 is in a sleep state, the row decoder 11 receives the normal row address output by the multiplexer 10. When the first control signal CT1 is in an enabled state, the row decoder 11 receives the redundant row address output by the multiplexer 10. The first control signal CT1 is configured to represent whether a word line corresponding to the normal row address is damaged and is repaired. The first control signal CT1 is in the sleep state before entering the enabled state.

It may be understood that in this embodiment, when the first control signal CT1 is in the enabled state, it represents that the word line corresponding to the normal row address is damaged, and the word line corresponding to the normal row address is the word line in the normal memory array 01. When being damaged, the word line corresponding to the normal row address is repaired by the word line in the redundant memory array 00. Therefore, when the first control signal CT1 is in the enabled state, the multiplexer 10 needs to output the redundant row address, and a word line corresponding to the redundant row address is in the redundant memory array 00, and is configured to repair the damaged word line in the normal memory array 01 previously mentioned. The word line in the normal memory array 01 may be referred to as a normal word line, and the word line in the redundant memory array 00 may be referred to as a redundant word line. If the word line corresponding to the normal row address is not damaged, the multiplexer 10 receives no redundant row address. When the multiplexer 10 receives the redundant row address, the first control signal CT1 is necessarily in the enabled state.

In this embodiment, before receiving the first control signal CT1 in the enabled state, the multiplexer 10 further receives the first control signal CT1 in the sleep state. The multiplexer 10 may first output, based on the first control signal CT1 in the sleep state, the normal row address to the row decoder 11. In comparison with the first control signal CT1 which has only one of the enabled state and the sleep state, the multiplexer 10 waits for the redundant row address after receiving the normal row address, and finally outputs only one row address. This embodiment helps optimize the time sequence, thereby preventing a small probability event such as damage to the normal word line from affecting the whole time sequence. In addition, even if the normal row address is first decoded by the row decoder 11 and some operation duration is occupied for first performing a subsequent operation, because the capacitance of the minimum memory unit 001 in the redundant memory array 00 is relatively large, a voltage difference required for performing amplification by the sense amplifier can still be provided when operation duration of the subsequent operation is shortened. Therefore, it can still be ensured that data corresponding to the redundant row address can be correctly read when the multiplexer 10 first outputs the normal row address.

In some embodiments, still referring to FIG. 2, a first decoder 12, a comparator 13, and a first encoder 14 are further included in the memory. An output terminal of the first decoder 12 is connected to a first input terminal of the multiplexer 10, an output terminal of the comparator 13 is connected to an input terminal of the first encoder 14, and an output terminal of the first encoder 14 is connected to a second input terminal of the multiplexer 10. The first decoder 12 is configured to receive a target row address and decode the target row address in a preset decoding manner, to output the normal row address. The comparator 13 is configured to: compare the target row address with at least one repaired row address, and if the target row address matches one of the at least one repaired row address, generate the first control signal CT1 with the enabled state, and output flag information of the matched repaired row address. The first encoder 14 is configured to receive the flag information, and generate the redundant row address based on the flag information.

In this embodiment, both the comparator 13 and the first decoder 12 receive the target row address, and the target row address is a row address of a to-be-activated word line. The first decoder 12 performs first-time decoding on the target row address, and the row decoder 11 performs second-time decoding on the normal row address. It may be understood that first-time decoding is partial decoding, and a result of second-time decoding may be either partial decoding or complete decoding. In some embodiments, second-time decoding is partial decoding, and final complete decoding is performed by a sub-word line driver (SWD). The target row address and the normal row address differ only in the degree of decoding, and the two point to the same word line. Whether decoding or encoding is performed, a pointed word line before and after decoding is necessarily the same, and a pointed word line before and after encoding is also the same, unless an information change occurs in the middle or another type of address mapping is performed. Because a comparison action usually takes a relatively long time, a moment at which the first decoder 12 outputs the normal row address is usually earlier than a moment at which the first encoder 14 outputs the redundant row address, or earlier than a moment at which the comparator 13 outputs the flag information.

In some embodiments, the comparator 13 stores the repaired row address or the comparator 13 receives a repaired row address sent by another component. Different repaired row addresses correspond to different flag information, and each piece of flag information corresponds to one redundant row address. For example, when a first normal word line is damaged, replacement repair is performed by utilizing the first redundant row address. In this case, the comparator 13 stores or receives the repaired row address (namely, the first normal word line) and flag information of the first redundant row address, and forms a mapping relationship between the redundant row address and the repaired row address, and the repaired row address is the same as the row address of the damaged normal word line. When the target row address matches one of the at least one repaired row address, the comparator 13 sends flag information corresponding to the matched repaired row address to the first encoder 14, and the first encoder 14 generates a redundant row address based on the flag information.

For simplicity of expression, the following is described in a manner in which the comparator 13 receives the repaired row address. It may be understood that the comparator 13 may receive only one repaired row address or receive no repaired row address (that is, no normal word line is damaged). The comparator 13 outputs no flag information when receiving no repaired row address, and the first encoder 14 outputs no redundant row address.

In different embodiments of this application, a presentation manner of the flag information changes with at least two structural features: (1) a correspondence between a normal memory array and a redundant memory array; and (2) the employment sequence of redundant word lines or redundant row addresses. For the first structural feature, the following possibilities exist: (1.1) The quantity of redundant memory arrays is equal to the quantity of normal memory arrays, different normal memory arrays have corresponding redundant memory arrays, and different normal memory arrays correspond to different redundant memory arrays. Alternatively, (1.2) the quantity of redundant memory arrays is less than the quantity of normal memory arrays, multiple redundant memory arrays are included in the memory, the normal memory arrays are divided into multiple groups, and each group shares one of the redundant memory arrays. Alternatively, (1.3) all normal memory arrays correspond to the same redundant memory array. For the second structural feature, the following possibilities exist: (2.1) The employment sequence of the redundant row addresses is based on the location relationship. For example, the first-time replacement repair is performed by the first redundant word line arranged based on the location relationship, the second-time replacement repair is performed by the second redundant word line arranged based on the location relationship, and the redundant row addresses corresponding to the redundant word lines are set based on the location relationship. (2.2) The employment sequence of the redundant word lines is according to another rule other than the location relationship. (2.3) The employment sequence of the redundant row addresses is irregular.

For the foregoing mentioned (1.1) and (1.2), before performing comparison, the comparator 13 needs to first determine, based on address information of the target row address, which redundant memory array corresponds to the target row address, and then compare the target row address with a repaired row address corresponding to the redundant memory array to determine whether the target row address matches the repaired row address. If the target row address matches the repaired row address, the comparator 13 outputs first flag information of the redundant memory array and second flag information of the matched repaired row address in one or more repaired row addresses corresponding to the redundant memory array. For example, there are five redundant memory arrays, and each redundant memory array employs five redundant word lines for replacement repair. The target row address may correspond to a third redundant memory array and match a fourth repaired row address of the third redundant memory array. In this case, the first flag information is configured to represent the third redundant memory array, and the second flag information is configured to represent the fourth repaired row address. The foregoing flag information is constituted by the first flag information and the second flag information. A corresponding redundant row address is generated by the first encoder 14 based on the first flag information and the second flag information. For the foregoing mentioned (1.3), only the second flag information is included in the flag information, and a corresponding redundant row address is generated by the first encoder 14 based on the second flag information.

For the foregoing mentioned (2.1), because a mapping relationship exists between location information and a redundant row address, for example, a number of a redundant row address corresponding to a first word line is 1, a number of a redundant row address corresponding to a second word line is 2, and ..., after a redundant memory array is determined (it is unnecessary to perform determining when there is only one redundant memory array), a redundant row address of a redundant word line may be generated by the first encoder 14 based on the location information and information about the redundant memory array. If there is only one redundant memory array, a redundant row address is generated only based on the location information. For the foregoing mentioned (2.2), because a rule exists between the location information and the redundant row address, a redundant row address of a redundant word line may be generated by the first encoder 14 based on the rule and the location relationship, or a redundant row address of a redundant word line is generated based on the rule, the location relationship, and information about a redundant memory array. For the foregoing mentioned (2.3), flag information of a repaired row address is address information of a redundant row address in a redundant memory array, and the first encoder 14 outputs the redundant row address based on the address information or based on the address information and information about the redundant memory array.

In some embodiments, in a case in which the foregoing structural feature (1.3) and the foregoing structural feature (2.3) are combined, the first encoder 14 may not be disposed, but the comparator 13 directly outputs the flag information corresponding to the matched repaired row address, and the flag information may be a redundant row address with the same degree of decoding as the normal row address.

It may be understood that the foregoing cases (1.1) to (1.3) may be randomly combined with the foregoing cases (2.1) to (2.3). Any combination is within the protection scope of this application. The difference is whether it is necessary to decode a part of address bits of the target row address to identify which redundant memory array is applied, and which manner to be employed to map a relationship between a repaired row address and a redundant row address. These are all within a range of expression manners of decoding and the flag information. A person skilled in the art may know how to implement a corresponding technical solution. Details are not described in this application.

In some embodiments, the first control signal CT1 is received by the multiplexer (MUX) 10 from the comparator 13 through a first connection line. The first control signal CT1 is in a sleep state by default, and becomes in an enabled state when the comparator 13 performs successful matching. In other words, the first connection line first transmits the first control signal CT1 in the sleep state, and then transmits the first control signal CT1 in the enabled state. In still some other embodiments, the first decoder is connected to a first control terminal of the multiplexer through a second connection line, to send the first control signal in the sleep state when the target row address is received or in a decoding process, so that the multiplexer outputs a decoded normal row address. The comparator is connected to a second control terminal of the multiplexer through a third connection line, to send the first control signal in the enabled state when matching succeeds, so that the multiplexer outputs an encoded redundant row address. In this case, the second connection line and the third connection line transmit only one of the first control signal in the sleep state or the enabled state.

In some embodiments, a latch 16 is further included in the memory. An output terminal of the latch 16 is connected to an input terminal of the first decoder 12 and an input terminal of the comparator 13, to latch an input target row address, to ensure that the first decoder 12 and the comparator 13 can effectively receive the target row address.

In some embodiments, an AND circuit 15 is further included in the memory. A first input terminal of the AND circuit 15 is connected to an output terminal of the multiplexer 10, a second input terminal of the AND circuit 15 is configured to receive an enable signal En, an output terminal of the AND circuit 15 is connected to an input terminal of the row decoder 11, and the enable signal En jumps to a high level before the multiplexer 10 outputs the normal row address. In this embodiment, the enable signal En is set through control, and the enable signal En is controlled to jump to a high level before the multiplexer 10 outputs the normal row address. This can ensure that the row decoder 11 can receive, in a timely manner, the normal row address or the redundant row address output by the multiplexer 10, and control the enable signal En to be disabled in an idle stage, thereby interrupting a subsequent operation, avoiding incorrect decoding of the row decoder 11, and reducing the power consumption of the memory.

In some embodiments, both the minimum memory unit in the redundant memory array 00 and the minimum memory unit in the normal memory array are one memory cell, and the capacitance of a memory cell in the redundant memory array is greater than the capacitance of a memory cell in the normal memory array. Alternatively, the minimum memory unit in the redundant memory array includes at least two memory cells, the minimum memory unit in the normal memory array is one memory cell, and a storage capacitance of the memory cell in the redundant memory array is less than or equal to a storage capacitance of the memory cell in the normal memory array. An access transistor and a storage capacitor are included in the memory cell, the gate of the access transistor is connected to the word line, and the source and the drain of the access transistor are respectively connected to the bit line and the storage capacitor. When the access transistor is turned on, a charge is shared between the storage capacitor and the bit line. The capacitance of the memory cell refers to a storage capacitance.

In some embodiments, the at least two memory cells included in the minimum memory unit in the redundant memory array 00 have the same row address and are connected to the same bit line. It should be noted that connected to the same bit line herein refers to finally connected to the sense amplifier through the same wire, so that after charge sharing, the bit line can have more or fewer charges (the comparison herein is a case in which the minimum memory unit includes only one memory cell), and a larger voltage difference is further formed between the bit line and the reference bit line, thereby ensuring that the sense amplifier can correctly amplify bit line data. In addition, two memory cells simultaneously provide charges for the bit line. Therefore, when charge sharing duration is insufficient or offset cancellation duration is insufficient, a voltage difference meeting an amplification requirement is still formed, so that data is correctly read.

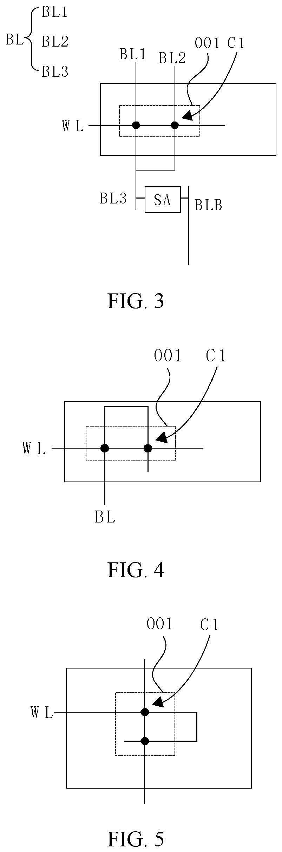

Referring to FIG. 3, a first portion BL1 and a second portion BL2 in parallel may be included in the bit line BL, and the first portion BL1 and the second portion BL2 are connected to the sense amplifier SA through a BL3, and the sense amplifier SA is configured to amplify a voltage difference between the bit line BL and the reference bit line BLB.

In some embodiments, after exiting the idle stage, the sense amplifier sequentially enters four stages: offset cancellation (OC), charge sharing (CS), amplification, and precharge, then, enters the idle stage again, and performs corresponding operations at different stages. The offset cancellation stage is employed to eliminate parameter mismatch of an internal transistor, and a result of the offset cancellation stage is that a potential difference exists between the bit line and the reference bit line before charge sharing, to compensate for a defect caused by a first threshold voltage being greater than or less than a second threshold voltage. The first threshold voltage is a threshold voltage of a transistor whose gate is connected to the bit line, and the second threshold voltage is a threshold voltage of a transistor whose gate is connected to the reference bit line. This plays a charge compensation role. Therefore, the offset cancellation stage is sometimes referred to as a mismatch compensation stage. In the charge sharing stage, the word line is opened, and the storage capacitor starts sharing a charge with the bit line. If the memory cell stores data 1, the charge of the bit line increases and the potential increases. If the memory cell stores data 0, the charge of the bit line decreases and the potential decreases. If an offset cancellation time is shorter than a preset cancellation time or a charge sharing time is shorter than a preset sharing time, when the data 1 is stored, the charge amount of the bit line is less than an expected charge amount, and the potential of the bit line is relatively low. When the data 0 is stored, the charge amount of the bit line is higher than the expected charge amount, and the potential of the bit line is relatively high.

It should be noted that, in different embodiments of this application, different stages of the sense amplifier are not strictly consecutive, and a specific interval may exist in the middle, to implement easing in a time sequence.

In some embodiments, the at least two memory cells included in the minimum memory unit in the redundant memory array are connected to the same word line. Referring to FIG. 4, the bit line BL is bent and intersects the same word line WL at different locations, a memory cell C1 is located at an intersection of the word line WL and the bit line BL, and the minimum memory unit 001 of the redundant memory array 00 is constituted by two memory cells C1 arranged in an extension direction of the word line WL. Alternatively, referring to FIG. 5, the word line WL is bent and intersects the same bit line BL at different locations, and the minimum memory unit 001 of the redundant memory array 00 is constituted by two memory cells C1 arranged in an extension direction of the bit line BL.

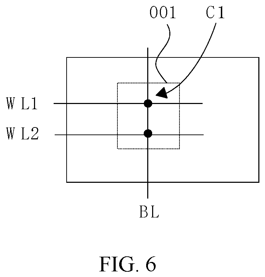

In still some other embodiments, the at least two memory cells included in the minimum memory unit in the redundant memory array are connected to at least two word lines having the same row address. Referring to FIG. 6, a first word line WL1 and a second word line WL2 have the same row address, and the first word line WL1 and the second word line WL2 are separately connected to the same bit line to form two memory cells C1. In this case, the minimum memory unit 001 of the redundant memory array 00 is constituted by the two memory cells C1 arranged in an extension direction of the bit line BL.

It should be noted that in any one of the foregoing embodiments, word line bending and bit line bending may be performed simultaneously, so that more than two memory cells are included in the minimum memory unit in the redundant memory array.

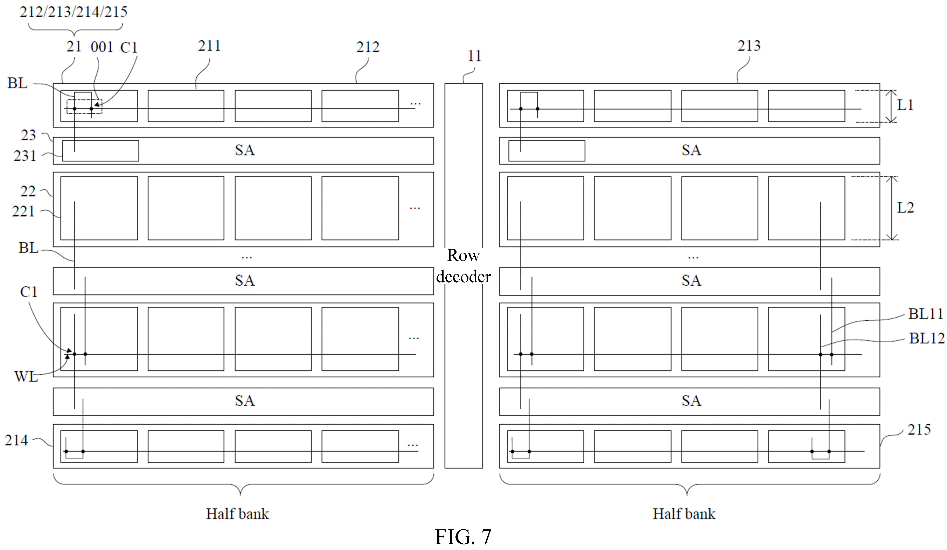

In still some other embodiments, an edge memory array and an intermediate memory array are included in the memory. In the extension direction of the bit line, the width of the edge memory array is equal to half the width of the intermediate memory array, the edge memory array serves as a redundant memory array, and the intermediate memory array serves as a normal memory array. Referring to FIG. 7, the row decoder 11 and half banks located on opposite sides of the row decoder 11 are included in the memory. Multiple memory portions are disposed in each half bank in a bit line direction, a sense amplifier array 23 is disposed between adjacent memory portions, and multiple sense amplifiers 231 are included in the sense amplifier array 23.

In this embodiment, two memory portions on two opposite sides are defined as edge memory portions 21, and a memory array located in the edge memory portion 21 is defined as an edge memory array 211. Multiple edge memory arrays 211 arranged in a word line WL direction are usually included in the edge memory portion 21. Correspondingly, a non-edge memory portion is defined as an intermediate memory portion 22, multiple intermediate memory portions 22 are usually included in each half bank, and each intermediate memory portion 22 is usually constituted by multiple intermediate memory arrays 221 extending in the word line WL direction. In the extension direction of the bit line BL, the width L1 of the edge memory array 211 is half the width L2 of the intermediate memory array 221, the redundant memory array is located in the edge memory array 211, and the normal memory array is located at least in the intermediate memory array 221.

In some embodiments, the edge memory array 211 serves as a redundant memory array, and the intermediate memory array 221 serves as a normal memory array. In some other embodiments, both the redundant memory array and the normal memory array are included in the edge memory array 211, and the intermediate memory array serves as a normal memory array. In still some other embodiments, both the redundant memory array and the normal memory array are included in both the edge memory array and the intermediate memory array.

It may be understood that the foregoing half is only an approximate value and does not need to be strictly limited, and a deviation range in size is allowed due to a process reason, layout arrangement, and power supply setting.

In some embodiments, still referring to FIG. 7, the memory adopts an open-BL mode. The so-called open-BL mode means that two adjacent bit lines (e.g., a first bit line BL11 and a second bit line BL12) connected to the same word line, respectively extend upward and downward, and are amplified by sense amplifiers 231 in different sense amplifier arrays 23, and the bit line and the reference bit line connected to the sense amplifier are respectively from two memory arrays on both upper and lower sides of the sense amplifier array 23 (the edge memory array 211 and the intermediate memory array 221 are included in the memory array). However, the memory array cannot be expanded infinitely in the bit line direction. Therefore, if the outermost side is the sense amplifier array, some bit lines have no available reference bit line. If the outermost side is the memory array, and the size of the edge memory array is the same as the size of the intermediate memory array, half of the bit lines cannot be amplified by the sense amplifier. Therefore, the size of the edge memory array is set to half the size of the intermediate memory array, and the bit line is bent, so that the length of the bit line in the edge memory array is close to the length of the bit line in the intermediate memory array, which helps make the parasitic capacitance of any bit line be close to the parasitic capacitance of the reference bit line, facilitating amplification by the sense amplifier.

In some embodiments, while the bit line BL of the edge memory array 211 is bent, the bit line BL is connected to two memory cells C1, which helps enhance the accuracy of data reading in the edge memory array 211, and alleviate the impact of noise, the row hammer effect, and the like on data reading. However, because the minimum memory unit in one redundant memory array is constituted by the two memory cells C1 in the edge memory array 211 together, data stored in the two memory cells C1 needs to be the same, and one minimum memory unit is constituted by one memory cell C1 in the intermediate memory array 221. Therefore, when the redundant memory array is located in the edge memory array 211 and the normal memory array is located in the intermediate memory array 221, the sum of the quantities of minimum memory units on two redundant word lines is equal to the quantity of minimum memory units on one normal word line. Similarly, when the normal memory arrays are located in the edge memory array 211 and the intermediate memory array 221, the quantity of minimum memory units on normal word lines in a part of the normal memory arrays (defined as a first normal memory array) located in the edge memory array 211 is equal to the quantity of minimum memory units on the redundant word line, and the quantity of minimum memory units on normal word lines in another part of the normal memory arrays (defined as a second normal memory array) located in the intermediate memory array 221 is equal to the quantity of minimum memory units on two redundant word lines.

It may be learned from the foregoing description that, when the redundant word line in the edge memory array is adopted to replace and repair the normal word line in the intermediate memory array, one-to-one manner cannot be adopted, but two-to-one manner should be adopted. When the redundant word line in the edge memory array is adopted to replace and repair the normal word line in the edge memory array, a two-to-two manner should be adopted. The reason why the two-to-two manner is adopted instead of the one-to-one manner is that two normal word lines in the edge memory array have the same row address, work simultaneously when data read and write are performed, and are usually damaged at the same time.

In some embodiments, the memory includes a first edge memory portion located in the upper left corner, where the first edge memory portion includes a first edge memory array 212, a second edge memory portion located in the upper right corner, where the second edge memory portion includes a second edge memory array 213, a third edge memory portion located in the lower left corner, where the third edge memory portion includes a third edge memory array 214, and a fourth edge memory portion located in the lower right corner, where the fourth edge memory portion includes a fourth edge memory array 215. In the two-to-one manner, two redundant word lines in the same edge memory array may be adopted to replace one damaged normal word line, or two redundant word lines in different edge memory arrays may be adopted to replace one damaged normal word line. Different edge memory arrays may be located on the same side of the row decoder 11, e.g., the first edge memory array 212 and the third edge memory array 214, or may be located on different sides of the row decoder 11, e.g., the first edge memory array 212 and the second edge memory array 213, or the first edge memory array 212 and the fourth edge memory array 215. The two redundant word lines adopted for replacement have the same row address. However, if the two redundant word lines are located in the same edge memory array, time sequences of the two word lines needs to be staggered, to separately perform amplification and read and write on a corresponding memory cell, that is, perform the foregoing four stages consecutively for two times: offset cancellation, charge sharing, amplification, and precharge.

It may be understood that, in some other embodiments, in the two-to-two manner, two normal word lines to be replaced are usually in the same edge memory array as two redundant word lines adopted for replacement. For example, it is assumed that a first normal word line and a second normal word line are included in the two normal word lines, and a first redundant word line and a second redundant word line are included in the two redundant word lines. If the first normal word line and the second normal word line are in the first edge memory array, the first redundant word line and the second redundant word line are in the first edge memory array. If the first normal word line is in the first edge memory array, and the second normal word line is in the second edge memory array, the first redundant word line is in the first edge memory array, and the second redundant word line is in the second edge memory array. In still some other embodiments, two normal word lines to be replaced and two redundant word lines adopted for replacement may usually be located in different edge memory arrays, and it is only necessary to ensure that the two normal word lines to be replaced have the same row address and the two redundant word lines adopted for replacement have the same row address.

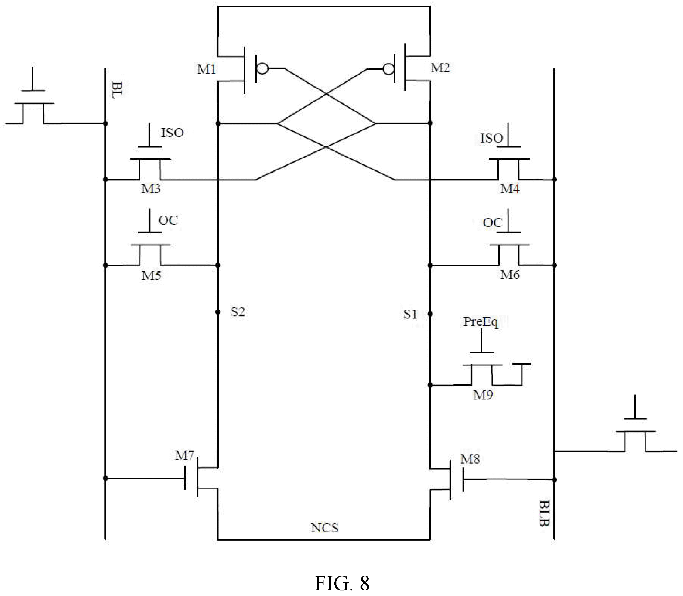

In some embodiments, the sense amplifier is further included in the memory. The sense amplifier is configured to amplify voltages of bit lines in the redundant memory array and the normal memory array, and perform offset cancellation on the internal transistor based on a compensation bit line or the reference bit line. Referring to FIG. 8, the sense amplifier may include a first P-type amplification transistor M1, a second P-type amplification transistor M2, a first N-type amplification transistor M7, a second N-type amplification transistor M8, a first isolation transistor M3, a second isolation transistor M4, a first offset cancellation transistor M5, a second offset cancellation transistor M6, and a precharge transistor M9. A first terminal of the first P-type amplification transistor M1 and a first terminal of the second P-type amplification transistor M2 are connected to a first voltage node PCS. A second terminal of the first P-type amplification transistor M1 is connected to a first terminal of the first N-type amplification transistor M7, and a second terminal of the second P-type amplification transistor M2 is connected to a first terminal of the second N-type amplification transistor M8. A second terminal of the first N-type amplification transistor M7 and a second terminal of the second N-type amplification transistor M8 are connected to a second voltage node NCS. The second terminal of the first P-type amplification transistor M1 serves as a second node S2, and the second terminal of the second P-type amplification transistor M2 serves as a first node S1. The first node S1 is connected to a first terminal of the first isolation transistor M3. A second terminal of the first isolation transistor M3, a second terminal of the first offset cancellation transistor M5, and the gate of the first N-type amplification transistor M7 are connected to the bit line BL. A first terminal of the first offset cancellation transistor M5 is connected to the second node S2, and the second node S2 is connected to a first terminal of the second isolation transistor M4. A second terminal of the second isolation transistor M4, a second terminal of the second offset cancellation transistor M6, and the gate of the second N-type amplification transistor M8 are connected to the reference bit line BLB. A first terminal of the second offset cancellation transistor M6 and a first terminal of the precharge transistor M9 are connected to the first node S1. The first isolation transistor M3 and the second isolation transistor M4 are turned on based on an isolation signal ISO, and the first offset cancellation transistor M5 and the second offset cancellation transistor M6 are turned on based on an offset cancellation signal OC. The precharge transistor M9 is turned on based on a precharge signal PreEq and transmits a precharge potential to the first node S1, so that the first node S1 and the second node S2 are at the precharge potential. Enabling of the precharge signal PreEq represents that the sense amplifier is in the precharge stage.

A structure of the sense amplifier shown in FIG. 8 and a common operation method thereof are all well-known technologies. Details are not described herein. It should be emphasized herein that, in the structure shown in FIG. 8, the first offset cancellation transistor M5 and the second offset cancellation transistor M6 play an offset cancellation role, and are mainly configured to cancel performance deviations of the first N-type amplification transistor M7 and the second N-type amplification transistor M8. Other sense amplifier circuits having an offset cancellation function are also within the protection scope of this application. In the offset cancellation stage, the first offset cancellation transistor M5 and the second offset cancellation transistor M6 are turned on, and the first isolation transistor M3 and the second isolation transistor M4 are turned off.

An embodiment of this application further provides a control method, applied to any one of the foregoing memory embodiments. The control method provided in this embodiment of this application requires only minimum hardware support, does not limit another function and implementation of hardware, and does not require hardware with another function. A person skilled in the art can design the corresponding structure according to the need, and only the corresponding part of the function needs to be satisfied..

In step 1, a target row address is compared with at least one repaired row address to determine whether they are matched, and first-time decoding is performed on the target row address to generate a normal row address.

In step 2, after the normal row address is generated, subsequent decoding is performed on the normal row address to determine a normal to-be-activated word line.

In step 3, a sense amplifier corresponding to the normal to-be-activated word line is controlled to perform an offset cancellation operation.

In step 4, if the target row address matches one of the at least one repaired row address, a redundant row address is generated based on flag information of the matched repaired row address, and a sense amplifier corresponding to the normal to-be-activated word line and not corresponding to the redundant row address is controlled to interrupt an offset cancellation operation, or the sense amplifier corresponding to the normal to-be-activated word line is controlled to interrupt the offset cancellation operation.

In step 5, after the redundant row address is generated, subsequent decoding is performed on the redundant row address to determine a redundant to-be-activated word line.

In step 6, a sense amplifier corresponding to the redundant to-be-activated word line is controlled to perform an offset cancellation operation.

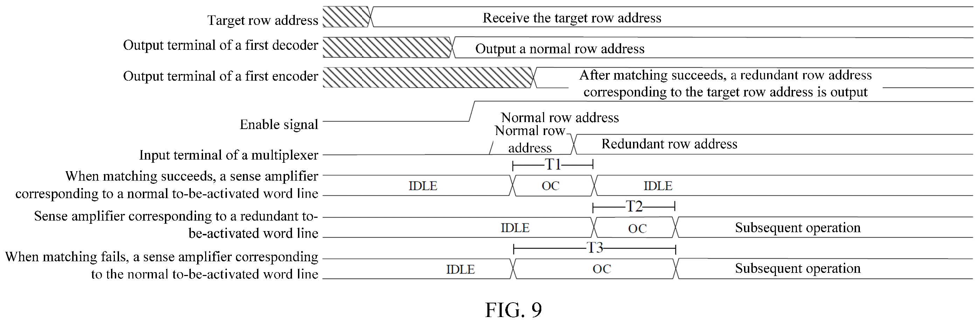

The following specifically describes the control method by taking an embodiment of a memory including a multiplexer, a row decoder, a first decoder, a comparator, an AND circuit, and a first encoder as an example. Refer to both FIG. 2 and FIG. 9. A filled region in FIG. 9 represents a state that does not enter a description of a subsequent unfilled region temporarily.

In step 1, the first decoder 12 and the comparator 13 simultaneously receive the target row address. The comparator 13 compares whether the target row address matches the at least one repaired row address, and the first decoder 12 performs first-time decoding. A comparison action and first-time decoding are performed simultaneously. After receiving the target row address for a period of time, the first decoder 12 outputs the normal row address. If the target row address matches (that is, is the same as) one of the at least one repaired row address, the first encoder 14 generates the redundant row address based on the flag information output by the comparator 13. Usually, a time for a comparing operation is longer than a time for first-time decoding. Therefore, if matching succeeds, a moment at which the first encoder 14 outputs the redundant row address is later than a time at which the first decoder 12 outputs the normal row address.

In step 2, the first decoder 12 performs first-time decoding, and subsequently the row decoder 11 and another component further need to perform further decoding. In the control method, decoding after first-time decoding is collectively referred to as subsequent decoding. In addition, in step 2, the normal to-be-activated word line is only determined, and the normal to-be-activated word line is not directly activated. Because activating a word line represents that a charge sharing operation needs to be performed, and the offset cancellation operation is performed before the charge sharing operation, a purpose of determining the normal to-be-activated word line is to find a sense amplifier for subsequent amplification, to further control the sense amplifier to perform the offset cancellation operation.

In step 3, because a memory array has not received a column selection signal, all sense amplifiers corresponding to the normal to-be-activated word line need to be controlled to perform the offset cancellation operation. It should be noted that if an intermediate memory portion in which the normal to-be-activated word line is located is adjacent to at least one edge memory portion in which the redundant to-be-activated word line/the redundant row address is located, some sense amplifiers corresponding to the normal to-be-activated word line are the same as some sense amplifiers corresponding to the redundant to-be-activated word line. Further, if two redundant word lines adopted to replace the normal word line are located in the same edge memory portion and the normal to-be-activated word line is located in the intermediate memory portion, sense amplifiers corresponding to the normal to-be-activated word line completely include sense amplifiers corresponding to the redundant to-be-activated word line. If two redundant word lines adopted to replace the normal word line are located in different edge memory portions and the normal to-be-activated word line is located in the intermediate memory portion, sense amplifiers corresponding to the redundant to-be-activated word line and sense amplifiers corresponding to the normal to-be-activated word line are partly the same. If two normal word lines to be replaced and two redundant word lines adopted for replacement are in the same edge memory portion, sense amplifiers corresponding to the normal to-be-activated word line and sense amplifiers corresponding to the redundant to-be-activated word line are exactly the same.

In step 4, if the target row address matches one of the at least one repaired row address, it indicates that replacement repair is performed on a damaged normal word line by adopting two redundant word lines. In this case, it is no longer necessary to attempt to amplify data in a memory cell corresponding to the normal word line. Therefore, the sense amplifier corresponding to the normal to-be-activated word line can be controlled to interrupt the offset cancellation operation.

In some embodiments, if an intermediate memory portion in which the normal to-be-activated word line is located is adjacent to at least one edge memory portion in which the redundant row address is located, because at least a part of sense amplifiers overlap, only an offset cancellation operation of a non-overlapping part of sense amplifiers can be interrupted, without interrupting an offset cancellation operation of an overlapping part of sense amplifiers. If an edge memory portion in which the normal to-be-activated word line is located is the same as an edge memory portion in which the redundant row address is located, a sense amplifier corresponding to the normal to-be-activated word line is completely overlapped with a sense amplifier corresponding to the redundant row address. Therefore, any sense amplifier performing the offset cancellation operation may not be interrupted.

By disposing an independent control unit to receive a first control signal and the redundant row address, and receive the normal to-be-activated word line or the normal row address, a sense amplifier that needs to interrupt the offset cancellation operation and a sense amplifier that does not need to interrupt the offset cancellation operation may be determined. It should be noted that sense amplifiers corresponding to word lines located in the same memory portion are the same. Therefore, as long as a decoded part of the redundant row address can represent a memory portion in which the redundant row address is located, it can be determined whether sense amplifiers corresponding to the redundant row address and the normal to-be-activated word line overlap. In some embodiments, a decoding module may be disposed in the control unit. When the degrees of decoding the redundant row address and the normal row address are insufficient, further decoding is performed to learn of memory portions in which the redundant row address and the normal row address are located.

In another embodiment, even if sense amplifiers corresponding to the redundant row address and sense amplifiers corresponding to the normal to-be-activated word line at least partly overlap, all the sense amplifiers corresponding to the normal to-be-activated word line are interrupted, thereby simplifying the control logic.

For step 5 and step 6, in some embodiments, after the redundant to-be-activated word line is determined, the corresponding sense amplifier is controlled to perform the offset cancellation operation. Because some or even all sense amplifiers may be in the offset cancellation stage (corresponding to the normal to-be-activated word line, but not interrupted due to being also corresponding to the redundant row address), only a remaining sense amplifier needs to be controlled to perform the offset cancellation operation. In some other embodiments, because offset cancellation operations of all sense amplifiers corresponding to the normal to-be-activated word line are interrupted, in this case, the sense amplifier corresponding to the redundant to-be-activated word line needs to be controlled to perform the offset cancellation operation again.

Referring to FIG. 9, in the third row time sequence, the first encoder outputs a redundant row address corresponding to the target row address if matching succeeds, or outputs no row address or is in a default state if matching fails. In the fourth row time sequence and the fifth row time sequence, an enable signal is enabled before an input terminal of the multiplexer receives the normal row address, so that the multiplexer can output the normal row address in a timely manner. For the sixth row and the seventh row, the sense amplifier corresponding to the normal to-be-activated word line enters the offset cancellation stage OC from the idle stage IDLE before a matching result is determined, and interrupts the offset cancellation stage and enters the idle stage IDLE again after matching succeeds. In this case, the sense amplifier corresponding to the redundant to-be-activated word line enters the offset cancellation stage OC from the idle stage IDLE, and performs a subsequent operation. When the eighth row represents that matching fails, the sense amplifier corresponding to the normal to-be-activated word line continues to be in the offset cancellation stage OC and performs a subsequent operation; or when it represents that matching succeeds, the overlapping part of sense amplifiers may continue to be in the offset cancellation stage OC and perform a subsequent operation because the operation does not need to be interrupted.

It should be noted that, before the matching result is given, all the sense amplifiers corresponding to the redundant row address are controlled to perform the offset compensation operations, and a sense amplifier corresponding to the normal row address corresponding to the target row address is controlled to perform an offset compensation operation. After the matching result is given, offset cancellation operations of a part of sense amplifiers are interrupted, and an offset cancellation operation of a needed sense amplifier is reserved, which causes great power consumption of the offset cancellation operation. It is equivalent to that a large quantity of useless offset cancellation operations need to be enabled in each activation operation for a small probability of matching, which causes a great increase in power consumption, and increases in a reliability requirement of power supply and noise.

In a time sequence diagram shown in FIG. 9, a start moment of the offset cancellation stage OC of the sense amplifier corresponding to the redundant to-be-activated word line is the same as an end moment of the offset cancellation stage OC of the sense amplifier corresponding to the normal to-be-activated word line. However, in another embodiment, the former may be later than the latter.

In some embodiments, further referring to FIG. 9, the sense amplifier corresponding to the normal to-be-activated word line performs an offset cancellation operation for a first preset time T1 before interrupting the offset cancellation operation, and the sense amplifier corresponding to the redundant to-be-activated word line performs an offset cancellation operation for a second preset time T2. The sum of the first preset time T1 and the second preset time T2 may be a fixed value, to ensure stability of a time sequence of the offset cancellation operations, or the second preset time T2 has a minimum value, to ensure that the sense amplifier can perform minimal offset cancellation.

In some embodiments, further referring to FIG. 9, if the target row address does not match any of the at least one repaired row address, the sense amplifier corresponding to the normal to-be-activated word line performs offset cancellation for a third preset time T3. The sum of the first preset time T1 and the second preset time T2 is a fixed value, the third preset time T3 is less than or equal to the fixed value, and the second preset time T2 is less than the third preset time. In this way, this helps ensure that the sense amplifier corresponding to the redundant to-be-activated word line can perform a minimal offset cancellation operation when matching succeeds.

A person of ordinary skill in the art may understand that the foregoing implementations are specific embodiments for implementing this application. In actual application, various modifications may be made to the forms and details of the implementations without departing from the spirit and scope of this application. Any person skilled in the art may make changes and modifications without departing from the spirit and scope of this application. Therefore, the protection scope of this application shall be subject to the scope defined by the claims.

## Claims

1. A memory, comprising:
a redundant memory array and a normal memory array, a word line in the redundant memory array being configured to repair a word line in the normal memory array, and a capacitance of a minimum memory unit in the redundant memory array being greater than a capacitance of a minimum memory unit in the normal memory array; and
a sense amplifier, configured to amplify voltages of bit lines in the redundant memory array and the normal memory array.

2. The memory according to claim 1, further comprising a multiplexer and a row decoder, wherein the multiplexer is configured to receive a normal row address, a redundant row address, and a first control signal, and a moment at which the redundant row address is received is later than a moment at which the normal row address is received; when the first control signal is in a sleep state, the row decoder receives the normal row address output by the multiplexer; when the first control signal is in an enabled state, the row decoder receives the redundant row address output by the multiplexer; and the first control signal is configured to represent whether a word line corresponding to the normal row address is damaged and is repaired, and the first control signal is in the sleep state before entering the enabled state.

3. The memory according to claim 2, further comprising a first decoder, a comparator, and a first encoder, wherein an output terminal of the first decoder is connected to a first input terminal of the multiplexer, an output terminal of the comparator is connected to an input terminal of the first encoder, and an output terminal of the first encoder is connected to a second input terminal of the multiplexer;
the first decoder is configured to receive a target row address and decode the target row address in a preset decoding manner, to output the normal row address;
the comparator is configured to: compare the target row address with at least one repaired row address, and if the target row address matches one of the at least one repaired row address, generate the first control signal with the enabled state, and output flag information of the matched repaired row address; and
the first encoder is configured to receive the flag information, and generate the redundant row address based on the flag information.

4. The memory according to claim 2, further comprising an AND circuit, wherein a first input terminal of the AND circuit is connected to an output terminal of the multiplexer, a second input terminal of the AND circuit is configured to receive an enable signal, an output terminal of the AND circuit is connected to an input terminal of the row decoder, and the enable signal jumps to a high level before the multiplexer outputs the normal row address.

5. The memory according to claim 1, wherein both the minimum memory unit in the redundant memory array and the minimum memory unit in the normal memory array are one memory cell, and a capacitance of a memory cell in the redundant memory array is greater than a capacitance of a memory cell in the normal memory array; or the minimum memory unit in the redundant memory array comprises at least two memory cells, and the minimum memory unit in the normal memory array is one memory cell.

6. The memory according to claim 5, wherein the at least two memory cells comprised in the minimum memory unit in the redundant memory array have a same row address and are connected to a same bit line.

7. The memory according to claim 6, wherein the at least two memory cells are connected to a same word line or at least two word lines having a same row address.

8. The memory according to claim 1, comprising an edge memory array and an intermediate memory array, wherein in an extension direction of a bit line, a width of the edge memory array is equal to half a width of the intermediate memory array, the redundant memory array is located in the edge memory array, and the normal memory array is located at least in the intermediate memory array.

9. The memory according to claim 1, wherein the memory is further configured to perform offset cancellation on an internal transistor based on a compensation bit line or a reference bit line.

10. A control method, applied to the memory according to claim 1, comprising:
comparing a target row address with at least one repaired row address to determine whether they are matched, and performing first-time decoding on the target row address to generate a normal row address;
performing, after the normal row address is generated, subsequent decoding on the normal row address to determine a normal to-be-activated word line;
controlling a sense amplifier corresponding to the normal to-be-activated word line to perform an offset cancellation operation;
generating, if the target row address matches one of the at least one repaired row address, a redundant row address based on flag information of the matched repaired row address, and controlling a sense amplifier corresponding to the normal to-be-activated word line and not corresponding to the redundant row address to interrupt an offset cancellation operation, or controlling the sense amplifier corresponding to the normal to-be-activated word line to interrupt the offset cancellation operation;
performing, after the redundant row address is generated, subsequent decoding on the redundant row address to determine a redundant to-be-activated word line; and
controlling a sense amplifier corresponding to the redundant to-be-activated word line to perform an offset cancellation operation.

11. The control method according to claim 10, wherein the sense amplifier corresponding to the normal to-be-activated word line performs an offset cancellation operation for a first preset time before the offset cancellation operation is interrupted, the sense amplifier corresponding to the redundant to-be-activated word line performs an offset cancellation operation for a second preset time, and a sum of the first preset time and the second preset time is a fixed value, or the second preset time has a minimum value.

12. The control method according to claim 11, wherein if the target row address does not match any of the at least one repaired row address, the sense amplifier corresponding to the normal to-be-activated word line performs an offset cancellation operation for a third preset time, a sum of the first preset time and the second preset time is a fixed value, the third preset time is less than or equal to the fixed value, and the second preset time is less than the third preset time.
